Europäisches Patentamt

(19) European Patent Office

Office européen des brevets

(11) Publication number : **0 398 688 B1**

(12) **EUROPEAN PATENT SPECIFICATION**

(45) Date of publication of patent specification :
22.02.95 Bulletin 95/08

(21) Application number : **90305298.3**

(22) Date of filing : **16.05.90**

(51) Int. Cl.⁶ : **H04B 1/38,** H04Q 7/00

(54) **Procedure for forming frequencies of a digital radio telephone.**

(30) Priority : **18.05.89 FI 892405**

(43) Date of publication of application :
**22.11.90 Bulletin 90/47**

(45) Publication of the grant of the patent :
**22.02.95 Bulletin 95/08**

(84) Designated Contracting States :
**AT BE CH DE DK ES FR GB GR IT LI LU NL SE**

(56) References cited :
**GB-A- 1 601 710**
**US-A- 4 186 343**
**US-A- 4 317 221**
**US-A- 4 476 575**
**US-A- 4 489 413**
**PATENT ABSTRACTS OF JAPAN, unexamined**
**applications, E field, vol. 13, no. 121, March 24,**
**1989 THE PATENT OFFICE JAPANESE GOV-**
**ERNMENT page 132 E 732**

(73) Proprietor : **NOKIA MOBILE PHONES LTD.**
**P.O. Box 86**
**SF-24101 Salo (FI)**

(72) Inventor : **Ikonen, Raimo**
**Kurvintie 1 as. 3**
**SF-25360 Pertteli (FI)**
Inventor : **Lonka, Pekka**
**Alastuvankatu 3 as. 4**
**SF-24240 Salo (FI)**
Inventor : **Mikkola, Pekka**
**Mokoistenkatu 1 as. 10**
**SF-24100 Salo (FI)**

(74) Representative : **White, Martin David et al**
**MARKS & CLERK,**
**57/60 Lincoln's Inn Fields**
**London WC2A 3LS (GB)**

## Description

The present invention concerns a procedure by which the frequencies required in a digital radio telephone based on time division multiplex channelling (TDMA), in particular in a radio telephone for the gsm system, in transmission and receiving can be formed.

As is known in the art, in the radio telephone at least two frequency synthesisers are in general used for the frequencies required by the transmitter and the receiver, whereby the stable local oscillator frequencies are generated for the modulators of the transmitter and for the demodulators of the receiver. In the radio telephone different oscillators are also used for forming clock frequencies for the logic of the telephone and the reference frequency for the radio frequency signal. This arrangement known in the art is appropriate for use also in the TDMA system, for instance in the totally digital gsm system (gsm = Groupe Special Mobile) covering all Europe and to be adopted into use in the middle of the year 1991.

US-A-4 317 221 discloses the use of a common frequency synthesizer to generate a transmitter frequency and a receiver frequency in a mobile communication system.

In analogous radio telephones, e.g. in 900 MHz systems, it is well known in the art to use one synthesiser for forming a mixer frequency, a RF signal received whereby being transmitted to an intermediate frequency, and a mixer frequency, whereby the intermediate frequency of the transmitter is raised to the transmission frequency.

The frequencies of the above systems are e.g. as follows.

```
Receiver:  receiving frequency         935 to 960 MHz
           intermediate frequency      50 MHz
           mixer frequency
           (local oscillator)          985 to 1010 MHz


Transmitter: transmission frequency    890 to 915 MHz


             intermediate frequency    95 MHz
             mixer frequency
             (local oscillator)        985 to 1010 MHz
```

As is noted, the difference between the intermediate frequencies, i.e. 45 MHz, is the same as the duplex interval of the system. Therefore, it is feasible to use only one synthesiser, the mixer frequency generated whereby being the same both for the transmitter and for the receiver. If the difference between the mixer frequencies were different from the duplex intervals, at least two synthesisers should be used. In a digital radio telephone in which the difference between the intermediate frequencies differs from the duplex interval, e.g. 52 MHz, at least two synthesisers should be used in addition for forming intermediate frequencies.

Using several synthesisers and oscillators in a digital radio telephone no doubt raises the manufacturing costs and requires more space on circuit boards, as well as increases the failure occurrence rate of the telephone.

According to the present invention there is provided a method of operating a transmitter and a receiver of a time division multiplex radio telephone being operated in a time division multiplex radio telephone system, in particular in the GSM system, for transmitting and receiving radio frequency signals, using a single common basic oscillator having a basic oscillator frequency and a single common synthesiser characterized by the steps of:

deriving a first receiver mixer frequency from the basic oscillator frequency,

applying to the transmitter a first transmitter mixer frequency, derived from the basic oscillator frequency multipled by two, for mixing with a modulating signal for producing an intermediate transmitter frequency signal, the first transmitter mixer frequency being different from the first receiver mixer frequency,

applying a third frequency, derived from the basic oscillator frequency divided by four, to the common synthesiser,

applying the output from the synthesiser of a second receiver mixer frequency to the receiver, for mixing with a received radio frequency signal for producing an intermediate receiver frequency signal,

applying the first receiver mixer frequency to the receiver, for mixing with the intermediate receiver frequency to produce a demodulated output signal, and

applying the output from the synthesiser, as a second transmitter mixer frequency, to the transmitter, for mising with the intermediate transmitter frequency for producing a transmitter radio frequency signal, the second transmitter frequency being different from the second receiver mixer frequency.

Further features of the present invention are described in the following description and in accordance with claims 2 and 3.

The basis for the invention lies in the idea that since in a system based on time division multiplexing, the transmitter and the receiver operate in different time intervals, the frequencies required thereby can be formed for the transmitter and the receiver by means of a common oscillator and a synthesiser.

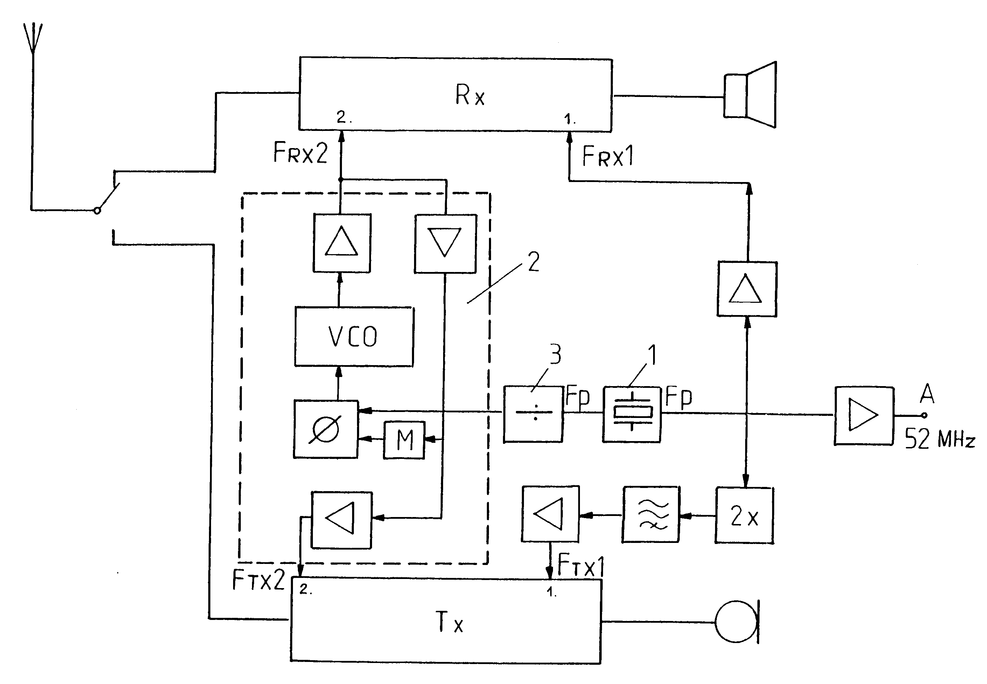

The procedure is described more in detail, referring to the block diagram of Fig. 1 in which only the most important blocks of operation required for understanding the procedure are presented.

The reference clock frequency according to the specification of the gsm system is 13 MHz. Therefore, for the basic frequency $f_p$ of the system can be appropriately used the frequency of the basic oscillator, i.e. 52 MHz, because when it is divided by four, for the frequency is obtained the required reference frequency, i.e. 13 MHz. The basic oscillator is a voltage-controlled crystal oscillator.

From said basic oscillator 1 the clock frequency of the logic of the telephone is obtained by dividing the frequency $f_p$=52 MHZ to be derived from the output A by four. A first mixer frequency $f_{Rx1}$ of the demodulator of the receiver Rx and a first mixer frequency $f_{Tx1}$ of the transmitter Tx are also derived from said basic oscillator frequency $f_p$. The first mixer frequency $f_{Rx1}$ of the receiver Rx is the same as the basic oscillator frequency $f_P$ which is carried through a buffer to the demodulator of the receiver, while the first mixer frequency (transfer oscillator frequency) $f_{Tx1}$ of the transmitter Tx is derived from the basic frequency $f_p$ by taking it through the frequency multiplier (multiplying by two), the filter and the buffer to the modulator of the transmitter. The first mixer frequency is therefore a second harmonic frequency of the basic frequency $f_p$, i.e. 104 MHz. The difference of the intermediate frequencies is thus 52 MHz.

The required second mixer frequencies of the transmitter Tx and the receiver Rx are established from the basic frequency $f_p$ by the aid of a synthesiser 2, comprising in a manner known in the art a voltage-controlled oscillator VCO of a phase comparator $\phi$ and requisite buffers. The inputs of the phase comparator $\phi$ are the divided frequency of the basic oscillator derived from the divider 3 and the frequency derived from the divider M. The input of the divider M is the frequency formed by the voltage-controlled oscillator VCO, which is thus the same as the frequency formed by the synthesiser 2. The divider M can be controlled, whereby with the control the frequency established by the synthesiser 2 can be selected. The synthesiser changes directly from one frequency to another without passing through the intermediate frequencies.

In the system the functioning is as follows. When a transmission period is in question, the synthesiser 2 generates a second mixer frequency $f_{Tx2}$ for the transmitter Tx, which is within the range of from 994 to 1010 MHz, depending on the transmission frequency. The first mixer frequency $f_{Tx1}$ (104 MHz) is obtained in the form of the second harmonic of the basic oscillator 1. When the transmission period ends and one moves to the receiving period, the synthesiser moves, controlled by the logic, at frequency of 7 MHz downwards, being tuned to the receiving channel corresponding to the transmission channel into a second mixer frequency $f_{Rx2}$ of the receiver Rx, i.e. into the range of 987 to 1012 MHz. The first mixer frequency $f_{Rx1}$ (52 MHz) of the receiver Rx is derived from the basic oscillator. When the receiving period is over, the synthesiser is tuned again for 7 MHz upwards to wait for another transmission period.

The frequencies have been so selected that the mutual modulation, error response and error transmission properties would be as appropriate as possible. Since the same synthesiser generates the mixer frequencies of both the transmitter and the receiver in the form of time divisions, it needs to be very fast. This is feasible because the non-modulated oscillator can be made to be fast.

The frequency distribution set forth is as follows:

**Receiver: receiving frequency**            **935 to 960 MHz**

| | | |
|---|---|---|
| 2nd mixer frequency | 987 to 1012 MHz | |
| intermediate frequency | 52 MHz + modulating frequency | |
| 1st mixer frequency (stable) | 52 MHz | |

| | | |
|---|---|---|
| Transmitter | 1st mixer frequency (transfer oscillator frequency, stable) | 104 MHz |
| | mixing frequency | 104 MHz + modulating frequency |
| | 2nd mixer frequency | 994 to 1019 MHz |
| | transmission frequency | 890 to 915 MHz |

It is obvious that the procedure of the invention is not concerned with the frequencies as such, thus, they may also be different from the ones presented above. It is essential that the second mixer frequencies are produced by means of one synthesiser common to the transmitter and the receiver, and the first stable mixer frequencies by one oscillator.

The procedure of the invention leads to a significant reduction in the number of components and therethrough, to reduced material and maintenance costs. Space saving on a circuit board enables manufacturing smaller and lighter telephones.

## Claims

1. A method of operating a transmitter and a receiver of a time division multiplex radio telephone being operated in a time division multiplex radio telephone system, in particular in the GSM system, for transmitting and receiving radio frequency signals, using a single common basic oscillator (1) having a basic oscillator frequency ($f_p$) and a single common synthesizer (2),
   characterized in the steps of:
   deriving a first receiver mixer frequency ($f_{Rx1}$) from the basic oscillator frequency ($f_p$),
   applying to the transmitter a first transmitter mixer ($f_{Tx1}$) frequency, derived from the basic oscillator frequency ($f_p$) multiplied by two, for mixing with a modulating signal for producing an intermediate transmitter frequency signal, the first transmitter mixer frequency ($f_{Tx1}$) being different from the first receiver mixer frequency ($f_{Rx1}$),
   applying a third frequency, derived from the basic oscillator frequency ($f_p$) divided by four, to the common synthesizer (2),
   applying the output from the synthesizer (2) as a second receiver mixer frequency ($f_{Rx2}$) to the receiver, for mixing with a received radio frequency signal for producing an intermediate receiver frequency signal,
   applying the first receiver mixer frequency ($f_{Rx1}$) to the receiver, for mixing with the intermediate receiver frequency to produce a demodulated output signal, and
   applying the output from the synthesizer (2), as a second transmitter mixer frequency ($f_{Tx2}$), to the transmitter, for mixing with the intermediate transmitter frequency for producing a transmitter radio frequency signal, the second transmitter frequency ($f_{Tx2}$) being different from the second receiver mixer frequency ($f_{Rx2}$).

2. A method in accordance with claim 1, characterized in that it further comprises the steps of:
   generating the second transmitter mixer frequency ($f_{Tx2}$) during the transmission time slot,
   decreasing a frequency of the synthesizer (2) by 7 MHz subsequent to the transmission time slot so as to be tuned to the receiving channel corresponding to the transmission frequency and generating throughout the receiving time slot the second receiver mixer frequency ($f_{Rx2}$), and

4

increasing the frequency of the synthesizer (2) by 7 MHz subsequent to the receiving time slot to wait for another transmission time slot.

3. A method in accordance with claim 1, characterized in that it further comprises the step of applying a fourth frequency derived from the first frequency ($f_p$) to the logic control of the time division multiplex system, the fourth frequency being a clock frequency for the logic control.

**Patentansprüche**

1. Verfahren zum Betreiben eines Senders und eines Empfängers eines Zeitteilpultiplex-Funktelefons, das in einem Zeitteilmultiplex-Funktelefonsystem betrieben wird, insbesondere im GSM-System, zum Senden und Empfangen von HF-Signalen, bei Verwendung eines einzigen Grundoszillators (1), der eine Oszillatorgrundfrequenz ($f_p$) hat, und eines einzigen, gemeinsamen Synthesizers (2), **gekennzeichnet durch die Schritte:**
   Ableiten einer ersten Empfängermischerfrequenz ($f_{Rx1}$) aus der Oszillatorgrundfrequenz ($f_p$),
   Zuführen einer ersten Sendermischerfrequenz ($f_{tx1}$) zum Sender, die aus der Oszillatorgrundfrequenz ($f_p$) durch Multiplizieren mit zwei abgeleitet ist, zum Mischen mit einem Modulationssignal zum Erzeugen eines Senderzwischenfrequenzsignals, wobei die erste Sendermischerfrequenz ($f_{Tx1}$) von der ersten Empfängermischerfrequenz ($f_{Rx1}$) abweicht,
   Zuführen einer dritten Frequenz, die aus der Oszillatorgrundfrequenz ($f_p$) durch Teilung durch vier abgeleitet ist, zum gemeinsamen Synthesizer (2),
   Zuführen des Ausgangs des Synthesizers (2) als zweite Empfängermischerfrequenz ($f_{Rx2}$) zum Empfänger zum Mischen eines empfangenen HF-Signals zum Erzeuen eines Empfängerzwischenfrequenzsignals,
   Zuführen der ersten Empfängermischerfrequenz ($f_{Rx1}$) zum Empfänger zum Mischen mit der Empfängerzwischenfrequenz zur Erzeugung eines demodulierten Ausgangssignals, und
   Zuführen des Ausgangs vom Synthesizer (2) als zweite Sendermischerfrequenz ($f_{Tx2}$) zum Sender zum Mischen mit der Senderzwischenfrequenz für die Erzeugung eines Sender-HF-Signals, wobei die zweite Sendermischerfrequenz ($f_{Tx2}$) von der zweiten Empfängermischerfrequenz ($f_{Rx2}$) verschieden ist.

2. Verfahren nach Anspruch 1, **dadurch gekennzeichnet**, daß es weiterhin die Schritte umfaßt:
   Erzeugen der zweiten Sendermischerfrequenz ($f_{Tx2}$) während des Sendezeitschlitzes,
   Vermindern einer Frequenz des Synthesizers (2) um 7 MHz im Anschluß an den Sendezeitschlitz, um auf den dem Sendekanal entsprechenden Empfangskanal abgestimmt zu werden, und Erzeugen der zweiten Empfängermischerfrequenz ($f_{RX2}$) während des Empfangszeitschlitzes, und
   Anheben der Frequenz des Synthesizers (2) um 7 MHz im Anschluß an den Empfangszeitschlitz, um auf einen weiteren Sendezeitschlitz zu warten.

3. Verfahren nach Anspruch 1, **dadurch gekennzeichnet**, daß es weiterhin umfaßt:
   Zuführen einer vierten Frequenz, die aus der ersten Frequenz ($f_p$) abgeleitet ist, zur Logiksteuerung des Zeitteilmultiplexsystems, wobei die vierte Frequenz eine Taktfrequenz für die Logiksteuerung ist.

**Revendications**

1. Procédé de fonctionnement d'un émetteur et d'un récepteur d'un radiotéléphone à multiplexage par répartition dans le temps mis en oeuvre dans un système de radiotéléphone à multiplexage par répartition dans le temps, en particulier dans le système GSM, pour l'émission et la réception de signaux radiofréquences, utilisant un seul oscillateur de base commun (1) ayant une fréquence d'oscillation de base ($f_p$) et un seul synthétiseur commun (2),
   caractérisé par les étapes consistant à :
   obtenir une première fréquence de mélangeur de récepteur ($f_{Rx1}$) à partir de la fréquence d'oscillation de base ($f_p$),
   appliquer à l'émetteur une première fréquence de mélangeur d'émetteur ($f_{Tx1}$) obtenue à partir de la fréquence d'oscillation de base ($f_p$) multipliée par deux, pour la mélanger avec un signal de modulation pour produire un signal de fréquence intermédiaire d'émetteur, la première fréquence de mélangeur d'émetteur ($f_{Tx1}$) étant différente de la première fréquence du mélangeur du récepteur ($f_{Rx1}$),

appliquer une troisième fréquence obtenue à partir de la fréquence d'oscillation de base ($f_p$) divisée par quatre, au synthétiseur commun (2), appliquer la sortie du synthétiseur (2), en tant que seconde fréquence du mélangeur du récepteur ($f_{Rx2}$), au récepteur, pour la mélanger avec un signal de radiofréquence reçu pour produire un signal de fréquence intermédiaire de récepteur,

appliquer au récepteur la première fréquence du mélangeur du récepteur ($f_{Rx1}$) pour la mélanger avec la fréquence intermédiaire du récepteur afin de produire un signal de sortie démodulé, et

appliquer à l'émetteur la sortie du synthétiseur (2), en tant que seconde fréquence de mélangeur d'émetteur ($f_{Tx2}$), pour la mélanger avec la fréquence intermédiaire d'émetteur pour produire un signal radiofréquence d'émetteur, la seconde fréquence d'émetteur ($f_{Tx2}$) étant différente de la seconde fréquence de mélangeur de récepteur ($f_{Rx2}$).

2. Procédé selon la revendication 1, caractérisé en ce qu'il comprend de plus les étapes consistant à :

générer la seconde fréquence de mélangeur d'émetteur ($f_{Tx2}$) pendant le créneau de temps d'émission,

diminuer la fréquence du synthétiseur (2) de 7 MHz après le créneau de temps d'émission de façon à ce qu'elle soit accordée sur le canal de réception correspondant à la fréquence d'émission et produire pendant tout le créneau de temps de réception la seconde fréquence de mélangeur de récepteur ($f_{Rx2}$), et

augmenter la fréquence du synthétiseur (2) de 7 MHz après le créneau de temps de réception en attente d'un autre créneau de temps d'émission.

3. Procédé selon la revendication 1, caractérisé en ce qu'il comprend de plus l'étape consistant à appliquer une quatrième fréquence obtenue à partir de la première fréquence ($f_p$) à la commande logique du système à multiplexage par répartition dans le temps, la quatrième fréquence étant une fréquence d'horloge destinée à la commande logique.